# EUROPÄISCHE PATENTSCHRIFT

(11) **EP 0 496 254 B1**
(45) Veröffentlichungstag und Bekanntmachung des Hinweises auf die Patenterteilung: **17.04.1996**
(21) Anmeldenummer: 92100548.4
(22) Anmeldetag: 15.01.1992
(51) Int. Cl.: G01R 27/14

(54) **Messvorrichtung zur elektrischen Messung eines Widerstandes sowie zugehöriges Messverfahren**
Measuring device for electrical measuring of resistance and method therefore
Dispositif de mesure pour mesurer électriquement la résistance et méthode pour cela

(30) Priorität: 23.01.1991 DE 4101819
(43) Veröffentlichungstag der Anmeldung: 29.07.1992
(73) Patentinhaber: FRAUNHOFER-GESELLSCHAFT ZUR FÖRDERUNG DER ANGEWANDTEN FORSCHUNG E.V., D-80636 München (DE)
(72) Erfinder: Konstanzer, Michael, Ing. grad., W-7800 Freiburg (DE); Huber, Reinhart, W-7880 Bad Säckingen (DE)
(74) Vertreter: Schmitt, Hans, Dipl.-Ing.

(56) Entgegenhaltungen:
- EP-A- 0 174 075
- WO-A-85/03348
- DE-A- 2 628 573

## Beschreibung

Die Erfindung bezieht sich auf eine Meßvorrichtung gemäß Oberbegriff der Anspruches 1 sowie eine Meßverstärker gemäß Oberbegriff des Anspruches 8.

Der elektrische Widerstand eines Mediums oder eines Festkörpers dient sehr häufig zur Bestimmung einer physikalischen Größe, beispielsweise der Temperatur. Die Messung des Widerstandes erfolgt bei einer Widerstandsfernmessung, indem ein Konstantstrom durch den zu messenden Widerstand geleitet wird, wobei die Spannung proportional zum Widerstand ist.

Dazu ist das sogenannte Zweileiter-Verfahren bekannt, bei dem vom Meßgerät zum zu messenden Widerstand zwei Leiter geführt sind, über welche der Konstantstrom fließt und gleichzeitig die Spannung gemessen wird. Dadurch addiert sich zum eigentlichen Widerstand des Prüflings der ohmsche Widerstand beider Leiter vom Meßgerät zum Prüfling. Sind diese beiden Leitungen über Steck- oder Klemmverbinder angeschlossen, addiert sich zusätzlich der Übergangswiderstand der Verbindungsstelle zum eigentlich zu messenden Widerstand. Dies macht sich insgesamt als erheblicher Fehler bemerkbar. Das Meßgerät muß deshalb auf die angeschlossene Leitung eingestellt werden. Ändert sich der Widerstand der Leitung durch Temperaturänderung beziehungsweise der Übergangswiderstand der Steck- beziehungsweise Klemmverbindung, zum Beispiel durch Oxydation, muß das Meßgerät neu kalibriert werden. Dies ist ein wesentlicher Nachteil der Zweileiter-Meßtechnik.

Um bei Messungen, wo das Auswertgerät nicht unmittelbar am Prüfling plaziert werden kann, tatsächlich nur den Spannungsabfall am Prüfling zu messen und nicht zusätzlich noch den Spannungsabfall über den Zuleitungen für den Konstantstrom, wird das sogenannte Vierleiter-Verfahren verwendet. Dabei sind neben den Stromzuführungen zwei weitere Leitungen zum Prüfling geführt. Daran kann direkt die Spannung über dem Prüfling erfaßt werden.

Nachteilig ist bei der Vierleiter-Meßtechnik unter anderem, daß ein erhöhter Verdrahtungsaufwand erforderlich ist. In praktischen Anwendungsfällen müssen die vier Leitungen häufig über Kontakte - Steckkontakte, Schleifkontakte oder dergleichen - geführt werden, so daß einerseits auch hierbei ein erhöhter Aufwand entsteht und andererseits eine größere Störanfälligkeit und die Gefahr von Meßfehlern vorhanden sind.

Aus der WO-A-85/03348, aus der der Oberbegriff des Anspruches 1 abgeleitet wurde, ist eine Meßanordnung für eine Tank-Füllstandsanzeige bekannt, bei der zu einem als Potentiometer ausgebildeten Meßwiderstand ein Kondensator parallel geschaltet ist. Die bei einem im Meßkreis fließenden Konstantstrom am Meßwiderstand abfallende Spannung wird über ein Meßinstrument angezeigt und ist ein Maß für den jeweiligen Füllstand. Der Kondensator dient hierbei zur Schwingungsdämpfung des Meßinstrumentes selbst und auch bei schwankendem Füllstand. Außerdem bewirkt der Kondensator ein gedämpftes Rückstellen des Meßwertes beim Umschalten des Meßbereiches.

Schließlich ist es auch bekannt, direkt bei dem Sensorwiderstand eine Elektronikschaltung zur Meßwertaufnahme und Verarbeitung zu plazieren. Dies wird insbesondere bei Temperaturmessungen häufig angewandt. Am Ausgang der Elektronikschaltung steht dann ein Meßsignal in Form eines Einheitssignales oder in digitaler Form an, das über größere Entfernungen übertragen werden kann. Nachteilig ist hierbei eine wesentlich vergrößerte Bauform des Sensors, da sich im Sensor auch noch die aktive Elektronik befindet. Diese Elektronik muß sehr robust sein und über einen großen Temperaturbereich arbeiten können, um in rauher industrieller Umgebung eingesetzt werden zu können.

Durch die eingebaute Elektronik benötigt der Sensor zusätzlich auch noch eine Energieversorgung.

Aufgabe der vorliegenden Erfindung ist es, eine Meßvorrichtung und ein Meßverfahren zu schaffen, bei dem jeweils die Vorteile der Zweileiter-Meßtechnik und der Vierleiter-Meßtechnik erhalten, deren Nachteile aber vermieden werden. Insbesondere soll eine hohe Meßgenauigkeit praktisch unabhängig von der Länge der Zuleitungen und damit den Widerständen im Meßkreis vorhanden sein, wobei nur zwei Zuleitungen vorgesehen sind. Innerhalb des Meßkreises an Kontaktstellen auftretende Thermospannungen sollen bei dem Meßverfahren zur Erhöhung der Meßgenauigkeit mitberücksichtigt werden können.

Weiterhin soll bei dem Meßverfahren bei sich ändernden Bedingungen ein Selbstabgleich vorhanden sein.

Die Lösung dieser Aufgabe ist in den Kennzeichnungsteilen des Vorrichtungsanspruches 1 und hinsichtlich des Meßverfahrens in Anspruch 8 wiedergegeben.

Durch den zum Meßsensor-Widerstand parallel geschalteten Kondensator kann nach dem Abschalten des Konstantstromes die Ladespannung des Kondensators, die dem Spannungsabfall über dem Meßsensor-Widerstand entspricht, gemessen werden. Leitungswiderstände wirken sich hierbei nicht mehr nachteilig aus, da im Meßkreis über die beiden Meßleitungen zum Zeitpunkt der Messung praktisch kein Strom fließt.

Die sich zwischen dem Zeitpunkt des Abschaltens des Konstantstromes und dem Messen der Kondensatorladespannung durch Entladung über den parallel geschalteten Meßsensor-Widerstand einstellende Spannungsabsenkung kann einerseits durch einen kurzen Zeitabstand zwischen Abschalten des Konstantstromes und Meßzeitpunkt klein gehalten werden und andererseits ist rechnerisch mit hoher Genauigkeit das Ermitteln der Meßspannung über dem Kondensator zum Zeitpunkt des Abschaltens des speisenden Konstantstromes gut möglich. Somit ist hier eine von der Leitungslänge und damit auch vom Leitungswiderstand zwischen dem Meßsensor-Widerstand mit parallel geschaltetem Kondensator und dem Meßgerät in weiten Grenzen unabhängige Messung möglich, bei der eine Zweileiter-Verbindung zum Meßsensor genügt.

Eine Weiterbildung der Meßvorrichtung sieht vor, daß die Stromquelle umpolbar ist und daß vorzugsweise zwei wahlweise schaltbare Stromquellen mit unterschiedlicher Stromflußrichtung vorhanden sind.

Vor der eigentlichen Messung des Meßsensor-Widerstandes kann dadurch der Meßkreis nacheinander mit unterschiedlichen Stromflußrichtungen bestromt werden. Die jeweils gemessenen Spannungsabfälle imgesamten Meßkreis können dann zur Bestimmung der auftretenden Thermospannung verwendet werden, indem die Differenz dieser Spannungen gebildet wird. Die Thermospannung steht somit als Größe zur Verfügung und kann bei der Messung berücksichtigt werden, was ebenfalls zur Erhöhung der Meßgenauigkeit beiträgt.

Zweckmäßigerweise weist der Meßverstärker zwei Eingänge auf, wobei ein an die Stromquelle anschließbarer Referenzwiderstand vorhanden ist, der anstelle der an den dazu parallel geschalteten Speicherkondensator angeschlossenen Leitungen mit den Eingängen des Meßverstärkers verbunden werden kann.

Der Konstantstrom kann dadurch praktisch unmittelbar vor der Messung des Sensorwiderstandes genau bestimmt werden, so daß sich eine Langzeitdrift der Konstantstromquelle nicht nachteilig auf das Meßergebnis auswirkt.

Eine Weiterbildung des Meßverfahrens sieht vor, daß nach dem Abschalten des Konstantstromes die Spannung am Speicherkondensator in Zeitabständen mehrfach gemessen und die Spannung am Sensor zum Umschaltzeitpunkt insbesondere durch lineare Interpolation errechnet wird.

Die Messung der Kondensatorspannung zu mehreren Zeitpunkten liefert gut auswertbare Meßwerte, aus denen die Kondensatorspannung zum Zeitpunkt des Abschaltens des Konstantstromes exakt errechnet werden kann.

Die Messung erfolgt dabei zweckmäßigerweise nur mit kurzem Zeitabstand zum Stromabschaltpunkt und auch im nahezu linearen Bereich der Kondensatorendladekurve. Berücksichtigt wird hierbei auch, daß die Messungen außerhalb von Einschwingvorgängen der zu messenden Spannung, die durch Leitungsinduktivitäten bedingt auftreten, vorgenommen werden.

Zusätzliche Ausgestaltungen der Erfindung sind in den weiteren Unteransprüchen aufgeführt.

Nachstehend ist die Erfindung mit ihren wesentlichen Einzelheiten anhand der Zeichnungen noch näher erläutert.

Es zeigt:
Fig. 1 ein Prinzipschaltbild einer Widerstands-Meßanordnung
Fig. 2 ein Blockschaltbild einer Meßeinrichtung,
Fig. 3 ein Ablaufschema eines Widerstands-Meßverfahrens und
Fig. 4 ein Diagramm des Spannungsverlaufes im Meßkreis.

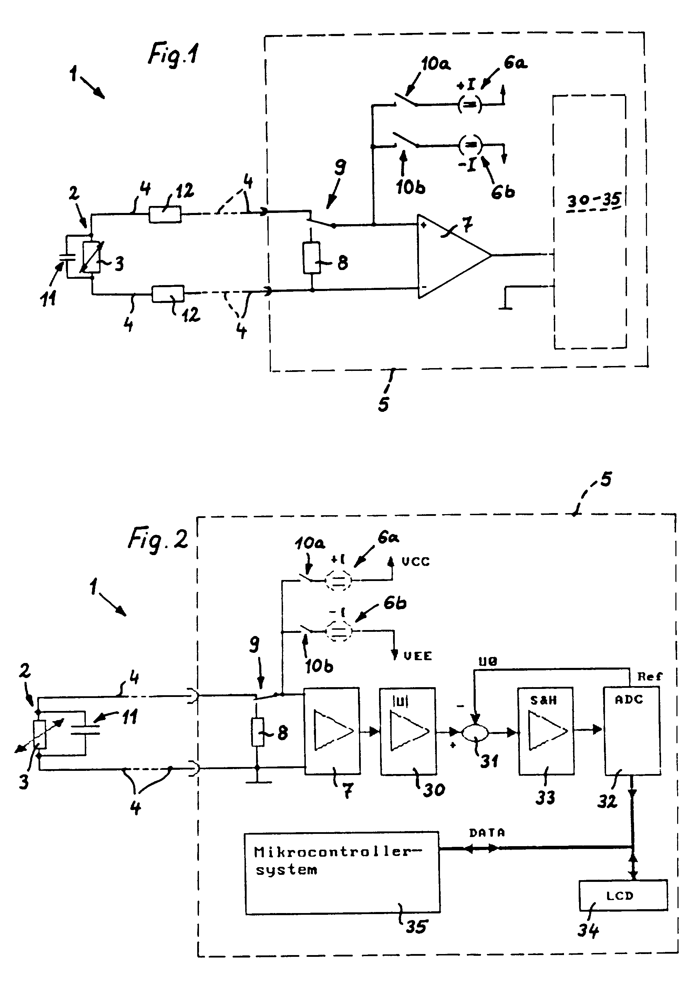

Eine in Fig. 1 im Grundprinzip dargestellte Meßvorrichtung 1 dient zur elektrischen Messung eines einen Meßsensor 2 bildenden Widerstandes 3. Der Meßsensor 2 ist an zwei Leitungen 4 angeschlossen, die zu einem Auswertgerät 5 führen, welches in Fig. 1 und 2 strichliniert umrandet ist. Die Leitungslänge kann mehrere Meter, z. B. 25 Meter betragen, so daß eine Verwendung der Meßvorrichtung 1 dort möglich ist, wo eine Meßsignalaufbereitung und Wandlung in digitale Form in der räumlichen Nähe des Sensors nicht möglich ist. Beispielsweise ist damit eine Temperaturmessung an weit vom Meßgerät entfernten Stellen, z. B. in Erd-Bohrlöchern oder bei Prozeßtemperaturmessungen in der chemischen Industrie und dergleichen möglich.

Das Auswertgerät 5 beinhaltet unter anderem Stromquellen 6a, 6b, einen Meßverstärker 7 sowie einen Referenzwiderstand 8. Außerdem ist noch ein Umschalter 9 sowie bei den Stromquellen 6a, 6b Schalter 10a, 10b vorgesehen.

Die durch die Leitungen 4 gebildeten Widerstände sind mit 12 bezeichnet. Parallel zum Meßsensor-Widerstand 3 ist ein Speicherkondensator 11 geschaltet. Dieser Speicherkondensator 11 bietet zusammen mit dem erfindungsgemäßen Meßverfahren die Möglichkeit, die am Widerstand 3 bei konstantem Meßkreisstrom abfallende Spannung ohne Einfluß der Leitungswiderstände 12 einschließlich von Übergangswiderständen an gegebenenfalls vorhandenen Steckkontakten und dergleichen zu bestimmen.

Prinzipiell erfolgt dies dadurch, daß der Speicherkondensator 11 beim Konstant-Bestromen des Meßkreises und dabei abfallender Meßspannung am Widerstand 3 aufgeladen wird und daß anschließend der Konstantstrom unterbrochen und die Spannung am Kondensator gemessen wird. Da in der Meßphase praktisch kein Strom in den Meßleitungen 4 fließt, wirken sich auch die Leitungswiderstände 12 dementsprechend nicht nachteilig aus.

Zu berücksichtigen ist dabei, daß der Meßkreiswiderstand, der aus einer Reihenausschaltung der Leitungswiderstände 12 und dem Meßwiderstand 3 gebildet ist, sehr viel kleiner ist als der Eingangswiderstand des angeschlossenen Meßvertärkers 7. Üblicherweise wird als Meßsensor-Widerstand ein Pt-100 mit einem Widerstandswert von 100 Ohm verwendet und die Leitungswiderstände 12 bewegen sich im Bereich von etwa 1 bis 10 Ohm. Dem steht ein Eingangswiderstand des Meßgerätes von mehr als 1 Megaohm entgegen.

Durch das erfindungsgemäße Meßprinzip kommt man trotz hoher Meßgenauigkeit mit nur zwei Leitungen 4 als Verbindungsleitungen zwischen dem Meßsensor 2 und dem Auswertgerät 5 aus. Um die Meßgenauigkeit noch weiter zu verbessern, weist die Meßvorrichtung 1 Einrichtungen auf, die ein Berücksichtigen der im Meßkreis auftretenden Thermospannung ermöglichen und auch Fehler durch Langzeitdrift bei den Stromquellen vermeiden.

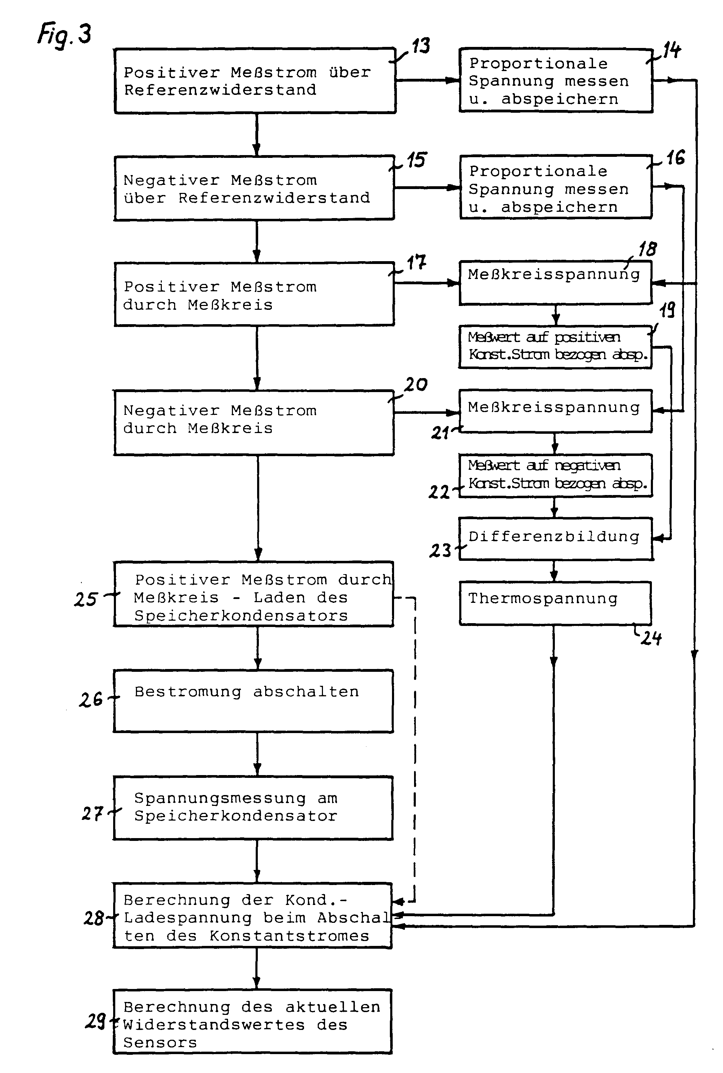

Ein Meßzyklus wird nachstehend anhand der Fig. 1 in Verbindung mit Fig. 3 beschrieben.

Die Stromquellen 6a und 6b sind Stromquellen für unterschiedliche Stromflußrichtungen, wobei die Stromquelle 6a für einen positiven Meßstrom und die Stromquelle 6b für eine negativen Meßstrom durch den Meßkreis dienen. Solche Stromquellen weisen über kurze Zeitabstände sehr konstante Werte auf, wobei Fehler lediglich durch eine Langzeitdrift auftreten können. Um dies zu elimenieren, wird vor jedem Meßvorgang zunächst der jeweilige Konstantstrom der Stromquellen 6a und 6b überprüft. Dazu dient der zu den Eingängen des Meßverstärkers 7 parallel geschaltete Referenzwiderstand 8. Wird nun der Umschalter 9 betätigt und damit mit dem Referenzwiderstand 8 verbunden und gleichzeitig die Stromquelle 6a über den Schalter 10a zugeschaltet, fließt über den Referenzwiderstand 8 der von der Stromquelle 6a gelieferte Konstantstrom und am Meßverstärker 7 steht eine am Referenzwiderstand 8 abfallende, zum Konstantstrom proportionale Spannung an. Dieser Meßwert wird abgespeichert. In Fig. 3 ist dieser Funktionsablauf durch die Blöcke 13 und 14 wiedergegeben. In gleicher Weise wird der Konstantstrom der Stromquelle 6b mit dann umgekehrter Stromflußrichtung überprüft und ebenfalls als Meßwert abgespeichert (vgl. Blöcke 15 und 16). Die beiden Meßergebnisse stellen die Größen der beiden Meßströme dar, die direkt in die Meßgenauigkeit eingehen. Da die Erfassung der Konstantströme unmittelbar vor der Messung des Meßsensor-Widerstandes 3 erfolgt, werden an die Langzeitstabilität der Stromquellen 6a, 6b keine besonderen Anforderungen gestellt.

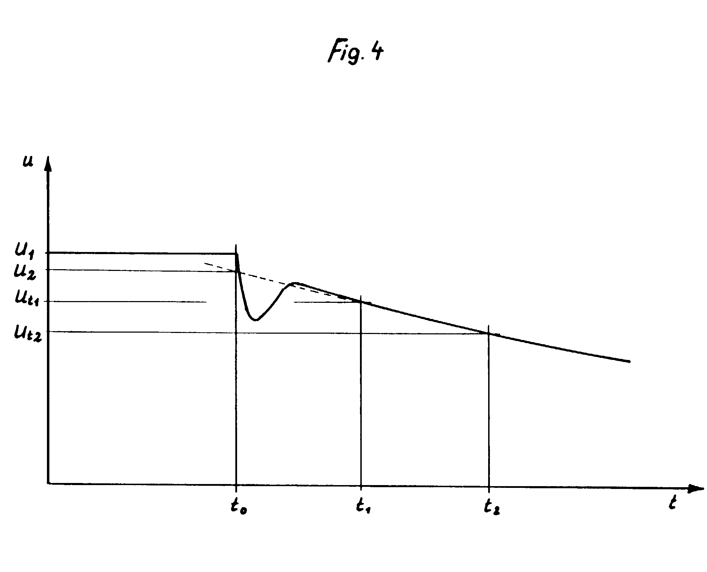

Nach dem Bestimmen der Konstantströme wird der Umschalter 9 wieder in die in Fig. 1 gezeigte Ausgangsstellung gebracht und durch Schließen des Schalters 10a erfolgt eine Bestromung des Meßkreises zunächst mit positivem Meßstrom. Die Meßkreisspannung U₁ (vgl. auch Fig. 4) setzt sich dabei aus den Spannungen über dem zu messenden Widerstand 3, der Spannung über den Leitungswiderständen 12 sowie der auftretenden Thermospannung im Meßkreis zusammen.

Dieser Meßabschnitt ist in Fig. 3 durch die Blöcke 17 bis 19 wiedergegeben. In gleicher Weise erfolgt anschließend eine Bestromung mit negativem Meßstrom entsprechend den Funktionsblöcken 20 bis 22.

Die Meßergebnisse entsprechend den Funktionsblöcken 19 und 22 sind jeweils auf die eingangs gemessenen Konstantströme bezogen. Dies ist durch die jeweilige Verbindung zwischen dem Funktionsblock 14 und dem Funktionsblock 18 einerseits und dem Funktionsblock 16 und Block 21 andererseits verdeutlicht.

Aus den beiden Meßergebnissen der positiven und der negativen Meßkreis-Betromung erfolgt anschließend gemäß Block 23 eine Differenzbildung, welche als Ergebnis die Thermospannung im Meßkreis ergibt (vgl. Block 24).

Es wird nun eine Bestromung des Meßkreises mit positivem Konstantstrom vorgenommen, wobei der Schalter 10a geschlossen ist und sich der Umschalter 9 in der in Fig. 1 gezeigten Stellung befindet. Die Bestromung erfolgt solange, bis der Speicherkondensator 11 sicher auf die Spannung U₁ über dem Widerstand 3 aufgeladen ist. Dann wird der Schalter 10a geöffnet und die Meßkreisspannung gemessen und gespeichert. Die Blöcke 25 bis 27 geben diesen Teil des Meßverfahrens wieder. Die unmittelbar zum Zeitpunkt des Abschaltens vorhandene Spannung ist die Spannung über dem Speicherkondensator 11 ohne Einfluß der Leitungswiderstände 12, da während der Meßphase kein Strom fließt.

In der Praxis kann nicht unmittelbar zum Umschaltzeitpunkt gemessen werden, da unter anderem der Umschaltvorgang selbst Zeit, z. B. einige Mikrosekunden benötigt. Die Spannung am Speicherkondensator 11 wird daher innerhalb der nach einer e-Funktion verlaufenden Endladekurve (Fig. 4) in Zeitabständen mehrfach gemessen, wobei der Zeitabstand zwischen dem Abschalten des Konstantstromes zum Zeitpunkt t₀ (Fig. 4) und der ersten Messung zum Zeitpunkt t₁ wesentlich kleiner als die Zeitkonstante des Entladestromkreises ist. Beispielsweise beträgt dieser Zeitabstand einige Mikrosekunden (3 bis 10 Mikrosekunden) und eine weitere Messung zum Zeitpunkt t₂ wird dann im Abstand zur ersten Messung wiederum nach einigen Mikrosekunden, z. B. 8 Mikrosekunden vorgenommen. Der Abstand der ersten Messung vom Strom-Abschaltzeitpunkt ist auch so gewählt, daß durch Leitungsinduktivitäten bedingte, kurzzeitige Spannungseinbrüche (Fig. 4) oder Anhebungen keinen störenden Einfluß haben, weil diese zum Zeitpunkt der ersten Messung (t₁,) abgeklungen sind.

Aus den gemessenen Kondensatorspannungen, der aus Block 24 zur Verfügung stehenden Thermospannung des Meßkreises sowie dem aus Block 14 zur Verfügung stehenden Konstantstrommeßwert wird dann in Block 28 die Ladespannung des Kondensators beim Abschalten des Konstantstromes berechnet. Dabei kann zur Überwachung des Meßkreises der Leitungswiderstand 12 (Fig. 1) auch noch mit berücksichtigt werden, da zum einen entweder aus Block 18 oder Block 25 die Meßkreisspannung bei positiver Bestromung und andererseits die Meßspannung am Speicherkondensator 11 nach dem Abschalten der Bestromung zur Verfügung steht. Die Differenz dieser Meßspannungen ist bezogen auf den positiven Meßstrom proportional zu den Leitungswiderständen. Dieser Leitungs-Widerstandsmeßwert kann auch zu Überprüfung der Meßleitungen 4 verwendet werden.

Bei der Berechnung der Kondensatorladespannung zum Zeitpunkt des Abschaltens des Konstantstromes gemäß Funktionsblock 28 wird die zwischen dem Abschalten der Bestromung und dem Messen der Spannung am Kondensator auftretende Spannungsabsenkung durch das bis dahin erfolgte Entladen des Speicherkondensators 11 über den Widerstand 3 mit berücksichtigt. Die Entladekurve wird dabei als Gerade (in Fig. 4 strichliniert angedeutet) behandelt, so daß mittels linearer Interpolation auf die Spannung zum Ausschaltzeitpunkt des Konstantstromes zurückgerechnet werden kann.

Im Funktionsblock 29 erfolgt eine Berechnung des aktuellen Widerstandswertes des Sensorwiderstandes 3, indem der Spannungsmeßwert aus Block 28 als normierte Größe mit dem Widerstandswert des Referenzwiderstandes, mit dem die Meßströme ermittelt wurden, mulipliziert wird. Als Ergebnis erhält man direkt den Wert des Widerstandes 3 in Ohm.

In Fig. 4 ist der Verlauf der Meßkreisspannung während eines Meßzyklus dargestellt.

Zunächst ist eine Meßkreisspannung U₁ während der Bestromungsphase vorhanden, die sich aus der am Sensor-Widerstand 3 abfallenden und damit auch am Speicherkondensator 11 anstehenden Sensorspannung U₂ und dem Spannungsabfall über den Leitungswiderständen 12 der Leitungen 4 zusammensetzt.

Wird nun zum Zeitpunkt t₀ der Konstantstrom abgeschaltet, sinkt die am Meßverstärker 7 anstehende Spannung auf U₂, da nun ohne Konstantstromfluß auch (praktisch) kein Spannungsabfall mehr über den Meßleitungen vorhanden ist.

Wie bereits vorerwähnt, wird die Spannung U₂ auch nicht direkt gemessen, da in diesem Ab- oder Umschaltbereich Spannungsschwingungen auftreten können, die ein exaktes Messen beeinträchtigen würden. Die Spannung U₂, die zum Zeitpunkt t₀ am Kondensator ansteht, kann aus den Spannungsmeßwerten Uₜ₁ und Uₜ₂ zu den Zeitpunkten t₁ und t₂ exakt berechnet werden.

Auch der Wert der Leitungswiderstände 12 kann für Überwachungszwecke direkt berechnet und berücksichtigt werden. Dabei wird die Differenz aus der gemessenen Spannung des Meßkreises mit Stromfluß und der errechneten Spannung über dem Sensor 2 ohne Stromfluß gebildet. Dividiert man diese Differenz durch den positiven Meßstrom, so erhält man eine Größe entsprechend dem Fehler durch Leitungswiderstände. Mulipliziert man diese Größe mit dem Wert des Referenzwiderstandes 8, so erhält man direkt den Widerstandswert der verwendeten Leitung zwischen dem Meß- bzw. Auswertgerät 5 und dem Sensor 2. Der Bezug auf den positiven Konstantstrom ist deshalb vorgesehen, weil damit die Bestimmung des Leitungswiderstandes unabhängig von der Größe des Stromes wird.

Wird durch Störeinflüsse der Leitungswiderstand zu groß, kann ein Alarm ausgelöst werden. Im Gegensatz zur bisherigen Zwei-Leitertechnik kann damit auch die Meßleitungsqualität überwacht werden. Es ist somit auch eine Selbstdiagnose der Meßleitungen möglich, wodurch die Meßsicherheit wesentlich erhöht werden kann.

Wenn der Meßwiderstand 3 als Festwidersand ausgebildet ist, kann der Leitungswiderstand selbst als Meßgröße ermittelt werden. Das erfindungsgemäße Meßverfahren kann somit in dieser abgewandelten Form auch zur exakten Überprüfung von Leitungen verwendet werden.

An den Speicherkondensator 11 sind bestimmte Anforderungen zu stellen, damit eine gute Qualität und Reproduzierbarkeit der Messung vorhanden ist. Die Kapazität des Kondensators spielt eine untergeordnete Rolle und kann in einem Bereich von beispielsweise 1 Mikrofarad bis 20 Mikrofarad variieren bei einem Sensorwiderstand von ca. 100 Ohm. Die untere Grenze ist bestimmt durch die Zeitkonstante des Entladungskreises, die wegen der vorgesehenen, linearen Interpolation einen bestimmten Wert nicht unterschreiten soll. Die obere Grenze des Kapazitätswertes ist durch den Meßzyklus bestimmt, in dem jeweils der Kondensator vollständig aufgeladen werden soll.

Ein wichtiger Parameter des Speicherkondensators 11 ist dessen Isolationswiderstand. Er sollte so groß wie möglich sein, damit durch ihn keine ins Gewicht fallenden Meßfehler auftreten. Wegen des hohen geforderten Isolationswiderstandes kommen Folienkondensatoren oder Kondensatoren mit metallisierter Folie als Speicherkondensatoren in Frage. Diese weisen einen wesentlich höheren Isolationswiderstand als mindestens gefordert - größer als 500 Kiloohm - auf, wobei übliche Werte mehr als 1.000 Megaohm sind. Der Speicherkondensator 11 sollte auch induktivitätsarm sein.

Das in den Fig. 1 und 2 strichliniert umgrenzte Auswertgerät 5 beinhaltet außer den in Fig. 1 erkennbaren Komponenten noch weitere, die zur Signalaufbereitung erforderlich sind. Die Signalaufbereitung geschieht im wesentlichen in vier Schritten. Als erstes wird das Signal um den Faktor 10 in dem Meßverstärker 7 verstärkt. Am Ausgang des Meßverstärkers 7 ist ein Präzisionsgleichrichter 30 angeschlossen, der in einem zweiten Schritt den Betrag aus dem Ausgangssignal des Meßverstärkers 7 bildet. Von der Ausgangsspannung des Präzisionsgleichrichters 30 wird bei einem nachfolgenden Umkehrverstärker 31 eine konstante Spannung (U₀) vom Meßsignal subtrahiert. Diese konstante Spannung wird direkt von einer Referenzspannungsquelle des Analog-Digital-Wandlers 32 abgeleitet. Durch diese Spannungsreduzierung kommt man bei dem Analog-Digital-Wandler -Wandler 32 mit einer Auflösung von 12 Bit anstatt 14 Bit aus.

Hinter dem Umkehrverstärker 31 ist ein Sample & Hold Verstärker 33 angeschlossen. Dieser dient zur Zwischenspeicherung der Meßwerte für den Zeitraum der Analog-Digital-Wandlung. In dem sich anschließenden Analog-Digital-Wandler -Wandler 32 werden die analogen Meßwerte in digitale Form umgesetzt.

Mit dem Analog-Digital-Wandler 32 ist noch eine alphanumerische Anzeige 34 sowie ein Mikrokontrollersystem 35 verbunden. Die Anzeige 34 dient einerseits zur Ausgabe des aktuellen Widerstandes- bzw. Temperaturwertes und kann auch zur Anzeige von Fehlermeldungen im Klartext benutzt werden. Zusätzliche Anzeigeelemente sind dadurch nicht mehr notwendig.

Das Mikrokontrollersystem 35 übernimmt die Ablaufsteuerung der Messung gemäß Fig. 3.

Die Bestromung des Meßkreises mit Konstantstrom wird intermittierend vorgenommen. Durch dieses diskontinuierliche Meßverfahren kann der Konstant-Meßstrom durch den Sensor so groß gewählt werden, daß ein gut zu verarbeitendes Signal entsteht, ohne daß aber der Sensor dabei selbst erwärmt wird. Eine zusätzliche Fehlerquelle wird dadurch vermieden.

In Versuchen hat sich gezeigt, daß mittels eines Pt 100 Widerstandes eine Temperatur im Bereich von 0°C bis 100°C mit einer Genauigkeit von 0,1 °C gemessen werden konnte. Insbesondere wurden dabei auch Versuche mit unterschiedlich langen Leitungen 4 zwischen dem Sensor 2 und dem Meßgerät 5 durchgeführt. Die Leitungslänge wurde dabei von zunächst 30 Zentimeter auf anschließend 15 Meter verändert. Es wurde hierbei ein Koaxialkabel verwendet. In üblicher ZweidrahtMeßtechnik würde sich dadurch eine Veränderung der Meßwertanzeige von 1,8°C ergeben.

Bei der erfindungsgemäßen Meßvorrichtung erfolgte automatisch eine Fehlerkorrektur und der angezeigte Meßwert war bei 30 Zentimeter Leitungslänge und 15 Meter Leitungslänge genau gleich. Auch als zusätzlich zur Meßleitung ein Kohleschichtwiderstand von bis zu 10 Ohm in die Leitung 4 geschaltet wurde, zeigte das Meßgerät exakt denselben Meßwert wie zuvor. Zu bemerken ist hierbei, daß 10 Ohm Widerstandsänderung beim Pt 100-Meßwiderstand einer Temperaturänderung von 20°C entsprechen würde.

Aus diesen Versuchsergebnissen ist auch erkennbar, daß bei sich änderndem Widerstand der Leitungen 4 durch Temperaturänderung, Änderung der Übergangswiderstände von Steck- bzw. Klemmverbindern z. B. durch Oxidation und dergleichen, bei der erfindungsgemäßen Meßvorrichtung 1 keine Neukalibrierung von außen erforderlich ist, da hier eine automatische Fehlerkorrektur vorgenommen wird und das exakte Meßergebnis trotz dieser Störgrößen erhalten bleibt.

Auch während eines Dauerbetriebes von 96 Stunden blieb der Anzeigewert innerhalb der vorgegebenen Fehlergrenzen. Die Anzeige blieb auch stabil, als die Meßwerterfassungshardware sowie der Speicherkondensator 11 parallel zum Pt 100-Meßwiderstand 3 mit einem Haarfön mehrere Minuten mit Warmluft angeblasen wurden.

Bei einem weiteren Versuch wurde ein Thermospannungssimulator in den Meßkreis geschaltet. Eine Thermospannung von +/- 100 Millivolt hatte keinen Einfluß auf das Meßergebnis, wobei zu beachten ist, daß die Thermospannung Blei/Kupfer nur - 0,31 Millivolt / 100 °C bzw. bei Kupfer/Nickel 1,22 Millivolt / 100 °C beträgt.

Mit den vorgenannten Versuchen konnte deutlich gezeigt werden, daß mit Hilfe der erfindungsgemäßen Meßvorrichtung bzw. dem zugehörigen Meßverfahren eine Widerstandsfernmessung mit der Genauigkeit der Vierleiter-Meßtechnik erreicht werden konnte, obwohl nur zwei Leitungen 4 benötigt werden.

## Patentansprüche

1. Meßvorrichtung (1) zur elektrischen Messung eines einen Meßsensor (2) bildenden Widerstandes (3), der an eine Stromquelle (6a,6b) anschließbar ist und an den mit einer Meßeinrichtung (7) verbindbare Leitungen (4) zur Messung des zum Konstantstrom proportionalen Spannungsabfalles an diesem Meßsensor-Widerstand (3) angeschlossen sind, wobei die Leitungswiderstände (12) und der Meßsensor-Widerstand (3) sehr viel kleiner als der Eingangswiderstand der Meßein-richtung (7) sind und wobei parallel zum Meßsensor-Widerstand (3) ein Speicherkondensator (11) geschaltet ist, und ein Umschalter (9, 10a, 10b) zum Verbinden des Speicherkondensators mit der Stromquelle (6, 6a) und der Meßeinrichtung (7) vorhanden ist, **dadurch gekennzeichnet,** daß die Meßeinrichtung ein Meßverstärker (7) ist und daß der Umschalter (9,10a,10b) derart geschaltet ist, daß er eine der an den Meßsensor-Widerstand (3) und den Speicherkondensator (11) angeschlossenen Leitungen (4) mit nur dem Meßverstärker (7) oder mit dem Meßverstärker (7) und der Stromquelle (6a,6b) verbinden kann.

2. Meßvorrichtung nach Anspruch 1, dadurch gekennzeichnet, daß die Stromquelle (6a,6b) umpolbar ist und daß vorzugsweise zwei wahlweise schaltbare Stromquellen (6a, 6b) mit unterschiedlicher Stromflußrichtung vorhanden sind.

3. Meßvorrichtung nach Anspruch 1 oder 2, dadurch gekennzeichnet, daß der Meßverstärker (7) zwei Eingänge aufweist und ein an die Stromquelle (6a, 6b) anschließbarer Referenzwiderstand (8) vorhanden ist, der anstelle der an den dazu parallel geschalteten Meßsensor-Widerstand (3) und Speicherkondensator (11) angeschlossenen Leitungen (4) mit den Eingängen des Meßverstärkers (7) verbunden werden kann.

4. Meßvorrichtung nach einem der Ansprüche 1 bis 3, dadurch gekennzeichnet, daß der zum Meßsensor (2) parallel geschaltete Speicherkondensator (11) unmittelbar an den Widerstand (3) angeschlossen ist, daß diese Parallelschaltung aus Meßsensor-Widerstand (3) und Speicherkondensator (11) über zwei Leitungen (4) mit der übrigen Meßanordnung (5) verbunden ist und daß diese Verbindungsleitungen (4) vorzugsweise durch ein Koaxialkabel gebildet sind.

5. Meßvorrichtung nach einem der Ansprüche 1 bis 4, dadurch gekennzeichnet, daß der Speicherkondensator (11) eine Kapazität zwischen etwa 1 Mikrofarad und etwa 2o Mikrofarad hat, daß der Kondensator induktivitätsarm ist und einen großen Isolationswiderstand, insbesondere größer als 5oo Kiloohm, vorzugsweise 1.ooo Megaohm oder mehr aufweist.

6. Meßvorrichtung nach einem der Ansprüche 1 bis 5, dadurch gekennzeichnet, daß der Speicherkondensator als Folien-Kondensator ausgebildet ist und als Isolierwerkstoff vorzugsweise Polycarbonat oder Polyprophylen vorhanden sind.

7. Meßvorrichtung nach einem der Ansprüche 1 bis 6, dadurch gekennzeichnet, daß zur Signalaufbereitung an den Ausgang des vorzugsweise als Instrumentenverstärker ausgebildeten Meßverstärkers (7) ein Präzisionsgleichrichter (3o) zur Betragsbildung des Meßwertes und an dessen Ausgang ein Sample & Hold Verstärker, Tastspeicherverstärker, (33) angeschlossen ist, daß der Sample & Hold Verstärker mit einem Analog-Digital-Wandler (32) verbunden ist und daß zur Ablaufsteuerung der Messung ein Mikrokontrollersystem (35) und zur Darstellung des Meßwertes eine vorzugsweise alphanumerische Anzeige (34) vorhanden sind.

8. Meßverfahren zum Bestimmen des Widerstandes eines in einem Meßkreis angeordneten Meßsensors (2) unter Verwendung einer Vorrichtung nach einem der Ansprüche 1 bis 7, wobei dazu durch den Meßsensor (2) ein konstanter Strom geleitet wird, wobei während der konstante Strom durch den Meßsensor-Widerstand (3) fließt, durch die am Meßsensor-Widerstand (3) abfallende Spannung ein parallel geschalteter Kondensator (11) aufgeladen wird und die Spannung am Kondensator gemessen wird, und wobei nach dem Aufladen des Kondensators der Konstantstrom abgeschaltet und dann die Spannung am Kondensator gemessen wird.

9. Verfahren nach Anspruch 8, dadurch gekennzeichnet, daß der Meßkreis nacheinander mit entgegengesetzter Stromflußrichtung und betragsgleichem Konstantstrom beaufschlagt und der jeweils im Meßkreis anstehende Gesamtspannungsabfall gemessen und gespeichert und die Differenz dieser Spannungsabfälle gebildet wird.

10. Verfahren nach Anspruch 8 oder 9, dadurch gekennzeichnet, daß vor der Messung der am Speicherkondensator (11) anstehenden Spannung der Konstantstrom gemessen wird.

11. Verfahren nach einem der Ansprüche 8 bis 10, dadurch ge kennzeichnet, daß nach dem Abschalten des Konstantstromes die Spannung am Speicherkondensator (11) in Zeitabständen mehrfach gemessen und die Spannung zum Umschaltzeitpunkt insbesondere durch lineare Interpolation errechnet wird.

12. Verfahren nach Anspruch 11, dadurch gekennzeichnet, daß die erste Spannungsmessung am Speicherkondensator (11) nach dem Einschwingen der Spannung auf eine nahezu lineare Entladekurve vorgenommen wird und daß die Zeit zwischen dem Abschalten des Konstantstromes und der ersten Messung wesentlich kleiner als die Zeitkonstante des Entladungskreises ist und daß sich diese Zeiten vorzugsweise wie etwa 1 zu 1o verhalten.

13. Verfahren nach Anspruch 11 oder 12, dadurch gekennzeichnet, daß zwei Spannungsmessungen am Speicherkondensator (11) vorgenommen werden und daß der zeitliche Abstand der zweiten Messung zum Abschaltzeitpunkt der Stromquelle etwa dem doppelten zeitlichen Abstand der ersten Messung zum Abschaltzeitpunkt entspricht.

14. Verfahren nach einem der Ansprüche 8 bis 13, dadurch ge kennzeichnet, daß die Strombeaufschlagung des Meßkreises intermittierend vorgenommen wird.

15. Verfahren nach einem der Ansprüche 8 bis 14, dadurch ge kennzeichnet, daß zur Bestimmung des Leitungswiderstandes (12), der bei Strombeaufschlagung auftretende Spannungsabfall im gesamten Meßkreis und anschließend die Spannung am Speicherkondensator (11) nach dem Abschalten der Strombeaufschlagung gemessen und die Differenz gebildet wird.

## Claims

1. Measuring device (1) for the electrical measurement of a resistor (3) forming a measuring sensor (2) which can be connected to a power source (6a, 6b) and to which leads (4), which can be connected to a measuring device (7) for measuring the voltage drop on this measuring sensor resistor (3) proportional to the constant current, are connected, wherein the lead resistances (12) and the measuring sensor resistor (3) are very much smaller than the input resistance of the measuring device (7) and wherein a storage capacitor (11) is connected in parallel to the measuring sensor resistor (3), and a changeover switch (9, 10a, 10b) for connecting the storage capacitor to the power source (6, 6a) and the measuring device (7) is available, **characterised in that** the measuring device is a measuring amplifier (7) and that the changeover switch (9, 10a, 10b) is connected in such a way that it can connect one of the leads (4) connected to the measuring sensor resistor (3) and the storage capacitor (11) to the measuring amplifier (7) only or to the measuring amplifier (7) and to the power source (6a, 6b).

2. Measuring device according to claim 1, characterised in that the polarity of the power source (6a, 6b) is reversible and that preferably two selectively switchable power sources (6a, 6b) with different direction of current flow are available.

3. Measuring device according to claim 1 or 2, characterised in that the measuring amplifier (7) comprises two inputs and a reference resistor (8) connectable to the power source (6a, 6b) is available which resistor can be connected to the inputs of the measuring amplifier (7) instead of the leads (4) connected to the measuring sensor resistor (3) and storage capacitor (11) connected in parallel to it.

4. Measuring device according to one of the claims 1 to 3, characterised in that the storage capacitor (11) connected in parallel to the measuring sensor (2) is connected directly to the resistor (3), that this parallel connection of measuring sensor resistor (3) and storage capacitor (11) is connected through two leads (4) to the remainder of the measuring arrangement (5) and that these connecting leads (4) are preferably formed by a coaxial cable.

5. Measuring device according to one of the claims 1 to 4, characterised in that the storage capacitor (11) has a capacitance between approximately 1 micro farad and approximately 20 microfarads, that the capacitor has low inductance and has a high insulation resistance, in particular greater than 500 kilohms, preferably 1,000 megohms or more.

6. Measuring device according to one of the claims 1 to 5, characterised in that the storage capacitor is constructed as a foil capacitor and preferably polycarbonate or polypropylene are present as insulating material.

7. Measuring device according to one of the claims 1 to 6, characterised in that for signal processing a precision rectifier (30) for summation of the measured value is connected at the output of the measuring amplifier (7) constructed preferably as an instrument amplifier and at its output a sample-and-hold amplifier, scan storage amplifier, (33) is connected, that the sample-and-hold amplifier is connected to an analogue-to-digital converter (32) and that a microcontroller system (35) is available for job control of the measurement and a preferably alphanumeric display (34) is available for presentation of the measured value.

8. Measurement method for determining the resistance of a measuring sensor (2) arranged in a measuring circuit using a device according to one of the claims 1 to 7, a constant current being conducted through the measuring sensor (2) for this purpose, wherein while the constant current flows through the measuring sensor resistor (3) a capacitor (11) connected in parallel is charged up by the falling voltage at the measuring sensor resistor (3) and the voltage at the capacitor is measured, and wherein after charging up the capacitor the constant current is turned off and then the voltage on the capacitor is measured.

9. Method according to claim 8, characterised in that the measuring circuit is acted upon in succession by a constant current of the same amount flowing in opposite directions and the total voltage drop occurring in the measuring circuit in each case is measured and stored and the difference between these voltage drops is found.

10. Method according to claim 8 or 9, characterised in that before the measurement of the voltage occurring on the storage capacitor (11) the constant current is measured.

11. Method according to one of the claims 8 to 10, characterised in that after turning off the constant current the voltage on the storage capacitor (11) is measured repeatedly at time intervals and the voltage at the moment of disconnection is calculated, especially by linear interpolation.

12. Method according to claim 11, characterised in that the first voltage measurement on the storage capacitor (11) is performed after the transient oscillations of the voltage on a nearly linear discharge curve and that the time between turning off the constant current and the first measurement is substantially smaller than the time constant of the discharge circuit and that these times have a ratio preferably of approximately 1 to 10.

13. Method according to claim 11 or 12, characterised in that two voltage measurements on the storage capacitor (11) are performed and that the time interval between the second measurement and the moment of turning the power source off corresponds approximately to twice the time interval between the first measurement and the moment of disconnection.

14. Method according to one of the claims 8 to 13, characterised in that the application of current to the measuring circuit is performed intermittently.

15. Method according to one of the claims 8 to 14, characterised in that in order to determine the lead resistance (12), the voltage drop occurring in the entire measuring circuit during application of current and the voltage on the storage capacitor (11) after switching off the application of current are measured and the difference found.

## Revendications

1. Dispositif de mesure (1) pour la mesure électrique d'une résistance (3) formant un capteur de mesure (2) et qui peut être raccordé à une source de courant (6a,6b) et à laquelle sont raccordées des lignes (4) qui peuvent être reliées à un dispositif de mesure (7) pour la mesure de la chute de tension, proportionnelle au courant constant, dans cette résistance (3) du capteur de mesure, et dans lequel les résistances (12) des lignes et la résistance (3) du capteur de mesure sont nettement plus faibles que la résistance d'entrée du dispositif de mesure (7), et dans lequel en parallèle avec la résistance (3) du capteur de mesure est branché un condensateur d'accumulation (11), et un commutateur (9,10a,10b) est prévu pour relier le condensateur accumulateur à la source de courant (6,6a) au dispositif de mesure (7), caractérisé en ce que le dispositif de mesure est un amplificateur de mesure (7) et que le commutateur (9,10a,10b) est branché de telle sorte qu'il peut relier l'une des lignes (4) raccordées à la résistance (3) du capteur de mesure et au condensateur accumulateur (11) uniquement à l'amplificateur de mesure (7) ou à l'amplificateur de mesure (7) et à la source de courant (6a,6b).

2. Dispositif de mesure selon la revendication 1, caractérisé en ce que la polarité de la source de courant (6a,6b) peut être inversée et qu'il est prévu de préférence deux sources de courant commutables au choix (6a,6b), dont les flux de courant ont des sens différents.

3. Dispositif de mesure selon la revendication 1 ou 2, caractérisé en ce que l'amplificateur de mesure (7) comporte deux entrées et qu'il est prévu une résistance de référence (8), qui peut être raccordée à la source de courant (6a,6b) et qui peut être reliée, non pas aux lignes (4) raccordées à la résistance (30) du capteur de mesure et au condensateur d'accumulateur (11), branchés en parallèle avec la résistance de référence, mais aux entrées de l'amplificateur de mesure (7).

4. Dispositif de mesure selon l'une des revendications 1 à 3, caractérisé en ce que le condensateur accumulateur (11), qui est branché en parallèle avec le capteur de mesure (2), est raccordé directement à la résistance (3), que ce montage en parallèle formé de la résistance (3) du capteur de mesure et du condensateur d'accumulateur (11) est relié au reste du dispositif de mesure (5) par l'intermédiaire de deux lignes (4) et que ces lignes de raccordement (4) sont formées de préférence par un câble coaxial.

5. Dispositif de mesure selon l'une des revendications 1 à 4, caractérisé en ce que le condensateur accumulateur (11) possède une capacité comprise entre environ 1 microfarads et environ 20 microfarads, que le condensateur présente une faible inductance et possède une résistance d'isolation élevée, notamment supérieure à 500 kilo.ohms, de préférence 1000 mégohms.

6. Dispositif de mesure selon l'une des revendications 1 à 5, caractérisé en ce que le condensateur accumulateur est réalisé en tant que condensateur en forme de feuille et qu'il est prévu comme matériau isolant de préférence du polycarbonate ou du polypropylène.

7. Dispositif de mesure selon l'une des revendications 1 à 6, caractérisé en ce que pour la préparation du signal, un redresseur de précision (3) servant à former la valeur absolue de la valeur de mesure est raccordée à la sortie de l'amplificateur de mesure (7) réalisé de préférence sous la forme d'un amplificateur d'instrument, et un amplificateur Sample & Hold, amplificateur des signaux d'échantillonnage et de maintien (33), est raccordé à la sortie de l'amplificateur de mesure, que l'amplificateur Sample & Hold est relié à un convertisseur analogique/numérique (32) et qu'il est prévu un système à microcontrôleur (35) pour la commande d'exécution de la mesure et un dispositif d'affichage de préférence alphanumérique (34) pour la représentation de la valeur de mesure.

8. Procédé de mesure pour la détermination de la résistance d'un capteur de mesure (2) disposé dans un circuit, moyennant l'utilisation d'un dispositif selon l'une des revendications 1 à 7, selon lequel à cet effet un courant constant est envoyé à travers le capteur de mesure (2), et selon lequel, pendant que le courant constant traverse la résistance (3) du capteur de mesure, un condensateur (11) branché en parallèle est chargé par la tension qui chute dans la résistance (3) du capteur de mesure et la tension aux bornes du condensateur est mesurée, et selon lequel après l'opération de charge du condensateur, le courant constant est interrompu, puis la tension aux bornes du condensateur est mesurée.

9. Procédé selon la revendication 8, caractérisé en ce qu'on charge le circuit de mesure successivement avec des courants constants de même valeur absolue et possédant des sens de flux de courant opposés, et qu'on mesure et qu'on mémorise la chute totale de tension, qui apparaît respectivement dans le circuit de mesure et qu'on forme la différence de ces chutes de tension.

10. Procédé suivant la revendication 8 ou 9, caractérisé en ce qu'on mesure le courant constant avant la mesure de la tension présente aux bornes du condensateur accumulateur (11).

11. Procédé suivant l'une des revendications 8 à 10, caractérisé en ce qu'après l'interruption du courant constant, on mesure la tension aux bornes du condensateur accumulateur (11) à plusieurs reprises pendant des intervalles de temps et qu'on calcule la tension à l'instant de commutation, notamment au moyen d'une interpolation linéaire.

12. Procédé selon la revendication 11, caractérisé en ce que la première mesure de tension aux bornes du condensateur accumulateur (11) est réalisée après la stabilisation de la tension sur une courbe de décharge approximativement linéaire et que la durée s'écoulant entre l'interruption du courant constant et la première mesure est nettement inférieure à la constante de temps du circuit de décharge, et que ces intervalles de temps sont de préférence dans le rapport d'environ 1 à 10.

13. Procédé suivant la revendication 1 ou 12, caractérisé en ce qu'on exécute deux mesures de tension aux bornes du condensateur accumulateur (11) et que l'intervalle de temps entre la seconde mesure et l'instant de débranchement de la source de courant correspond approximativement au double de l'intervalle de temps entre la première mesure et l'instant de débranchement.

14. Procédé suivant l'une des revendications 8 à 13, caractérisé en ce qu'on réalise de façon intermittente l'application de courant au circuit de mesure.

15. Procédé suivant l'une des revendications 8 à 14, caractérisé en ce que pour la détermination de la résistance (12) de la ligne, on mesure la chute de tension, qui apparaît lors de l'application du courant, dans l'ensemble du circuit de mesure, puis la tension aux bornes du condensateur accumulateur (11) après la suppression d'application de courant et qu'on forme la différence.
